(19) Europäisches Patentamt / European Patent Office / Office européen des brevets

(11) **EP 1 408 557 B1**

(12) **FASCICULE DE BREVET EUROPEEN**

(45) Date de publication et mention
de la délivrance du brevet:
**23.07.2008 Bulletin 2008/30**

(51) Int Cl.:
***H01L 31/052*** (2006.01)  ***H01L 31/045*** (2006.01)
***B64G 1/44*** (2006.01)

(21) Numéro de dépôt: **03292403.7**

(22) Date de dépôt: **30.09.2003**

(54) **Panneau de générateur solaire et vehicule spatial comportant un tel panneau**

Solargenerator-Paneel und Raumfahrzeug mit diesem Paneel

Solar generator panel and spacecraft with such panel

(84) Etats contractants désignés:
**AT BE BG CH CY CZ DE DK EE ES FI FR GB GR HU IE IT LI LU MC NL PT RO SE SI SK TR**

(30) Priorité: **10.10.2002 FR 0212574**

(43) Date de publication de la demande:
**14.04.2004 Bulletin 2004/16**

(73) Titulaire: **Alcatel Lucent**
**75008 Paris (FR)**

(72) Inventeurs:
• **Boulanger, Bernard**
**83600 Frejus (FR)**

• **Legrand, Silvain**
**06300 Nice (FR)**

(74) Mandataire: **Esselin, Sophie et al**
**Marks & Clerk France**
**31-33 Avenue Aristide Briand**
**94117 Arcueil Cedex (FR)**

(56) Documents cités:
**EP-A- 0 976 655          EP-A- 1 174 342**
**US-A- 6 017 002          US-A- 6 075 200**
**US-A- 6 118 067          US-B1- 6 177 627**
**US-B1- 6 188 012**

EP 1 408 557 B1

## Description

La présente invention est relative, d'une manière générale, au domaine des panneaux de générateur solaire, notamment pour applications spatiales. Elle concerne plus particulièrement un panneau de générateur solaire, notamment pour véhicule spatial, comprenant au moins un réflecteur pour la réflexion du rayonnement solaire sur au moins une cellule photovoltaique du panneau.

Un panneau de générateur solaire transporté dans un véhicule spatial, tel qu'un satellite, comprend en généra) :

- un panneau support d'un réseau de cellules photovoltaïques formant des chaîne de cellules ("strings" en anglais), transformant l'énergie solaire en énergie électrique,
- un réseau de réflecteurs qui concentrent les rayonnements solaires sur les précédents grâce à un revêtement aux propriétés adéquates.

De tels panneaux de générateur solaire peuvent être répartis selon des configurations très diverses. Il s'agit classiquement d'une succession longitudinale, parallèle à une direction s'éloignant du corps du véhicule spatial et autour de laquelle le générateur est destiné à tourner pour suivre le soleil. Toutefois, pour augmenter la puissance électrique disponible, il a été proposé de disposer, en plus des panneaux précédents, des panneaux supplémentaires latéraux. On connaît aussi des configurations dans lesquelles les panneaux sont disposés selon une direction transversale, c'est à dire selon une direction transversale à la direction longitudinale précitée selon laquelle s'étend l'étrier ou bras d'éloignement ("yoke" en anglais) qui relie le générateur au corps du véhicule spatial, et autour de laquelle le générateur est adapté à tourner pour suivre le soleil.

Lors du lancement, ce générateur est replié et ses panneaux sont empilés les uns sur les autres dans une configuration appelée configuration gerbée ou de gerbage.

La mise en service opérationnel du générateur, par exemple lorsque le véhicule est un satellite mis sur son orbite de service, impose de déplier l'empilement de panneaux : on parle alors de dégerbage.

Pour passer de la configuration de gerbage à la configuration déployée, dans laquelle les panneaux solaires sont disposés sensiblement dans un même plan, les panneaux sont articulés deux à deux, soit au moyen d'articulations ayant des éléments adjacents articulés autour d'un axe de pivotement et solidarisés chacun à l'un de deux panneaux voisins, soit au moyen d'articulations reliant des bords parallèles de panneaux.

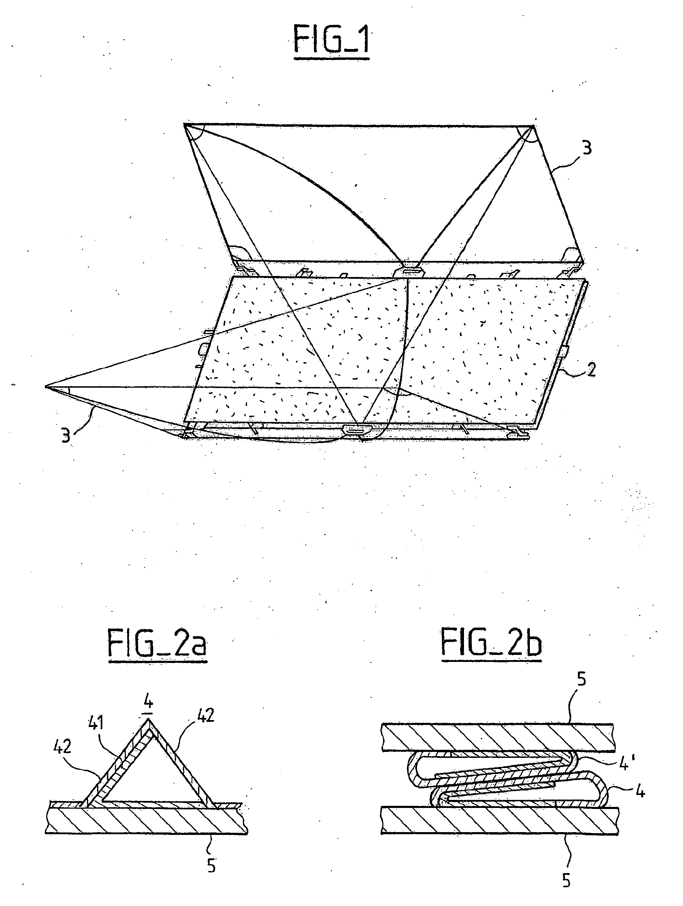

Concernant la méthode de concentration des rayonnements solaires, il a été proposé, dans un premier temps, tel qu'illustré sur la figure 1, un système 1, dit à auge, attrayant de part son apparente simplicité de mise en oeuvre. Celui-ci consiste à déployer de part et d'autre d'un panneau solaire 2 traditionnel, deux réflecteurs souples qui permettent, géométriquement, de doubler la surface collectrice de flux solaire. Cependant, ce système souffre de plusieurs inconvénients, notamment celui du modèle thermique adopté et surtout celui de présenter une limite technologique en termes de facteur de concentration et donc de puissance. En outre, il paraît difficile de maintenir les films réfléchissants en configuration optimale, des défauts de planéité ou de rigidité risquant d'apparaître. Un problème supplémentaire réside en ce que l'impact de défauts sur les réflecteurs (trous, plis) engendre une non-uniformité sur la surface active, provoquant alors l'apparition de phénomènes dits de "points chauds" : de fortes variations de courant peuvent surgir d'une chaîne de cellules à une autre, liées à la non-uniformité de distribution du flux solaire.

Afin de pallier ces différents inconvénients, il est apparu, dans un second temps, un nouveau concept de concentration. Selon ce concept, un panneau de générateur présente une succession alternée de chaînes de cellules et de réflecteurs. La concentration se réalise alors localement au niveau des cellules, conférant au système utilisé l'appellation usuellement admise de système à concentration locale.

Ce type de système à concentration locale est, par exemple, décrit dans le brevet US 6,177,627 et illustré sur les figures 2a et 2b de la présente demande. La figure 2a illustre un réflecteur 4 supporté par un panneau 5. Le réflecteur 4, de section triangulaire, est formé d'une partie 41 métallique et flexible, recouverte sur ses deux parois ouvertes vers l'espace d'une feuille 42 métallique flexible apte à réfléchir le rayonnement solaire. En position déployée, le réflecteur est naturellement tendue selon la figure 2a, la partie 41 étant formée d'un matériau se dressant naturellement dans sa position érigée. Par contre, lorsque les panneaux 5 sont dans leur configuration gerbée, tel que représenté sur la figure 2b, les panneaux en regard sont agencés de manière à minimiser l'espace existant entre eux, compressant au maximum les réflecteurs 4 et 4' en regard l'un de l'autre.

Or, dans cette position contrainte, les surfaces des deux réflecteurs en contact l'une avec l'autre étant celles des feuilles réfléchissantes, celles-ci risquent de se dégrader considérablement par frottement et, par suite, de ne plus pouvoir remplir leur fonction réfléchissante.

Le document US-6,118,067 décrit un système de concentration basé sur une architecture à trois panneaux suivant deux articulations, comprenant un panneau de cellules photovoltaïques, un panneau radiateur formant un angle entre 90° et 180° avec celui des cellules, et un panneau réflecteur articulé sur le panneau radiateur.

La présente invention a donc pour objectif de remédier aux problèmes exposés ci-dessus en proposant un panneau de générateur solaire comportant un réflecteur dont la surface fonctionnelle de réflexion ne puisse pas souffrir, en configuration gerbée, de dégradations, par exemple par frottements.

A cet effet, l'invention a pour objet un panneau de générateur solaire, notamment pour véhicule spatial, selon la revendication 1, comprenant au moins un réflecteur pour la réflexion du rayonnement solaire sur au moins une cellule photovoltaïque du panneau. Le réflecteur est formé d'une lame de matériau flexible, une première extrémité étant fixée sur le panneau alors que la seconde demeure libre. Les propriétés mécaniques du matériau sont déterminées de manière maintenir dressée la lame, dans une première position, où l'extrémité libre pointe vers l'espace extérieur en l'absence de pression verticale, définissant ainsi une première face dite supérieure faisant face à l'espace extérieur alors que la face opposée dite inférieure fait face au panneau, et de manière à, dans une seconde position, pouvoir présenter sa face supérieure orientée vers le plan du panneau en réponse à une pression verticale.

Selon l'invention, le panneau comporte une pluralité de réflecteurs regroupés par couples dont les faces inférieures sont en regard dans leur première position, les réflecteurs de chaque couple étant en contact au moins par leur extrémité libre, au moins l'une des faces supérieures de chaque couple étant orientée vers le plan du panneau dans leur seconde position.

Ainsi, la surface fonctionnelle de réflexion du réflecteur, qui est la face supérieure, est entièrement protégée de toute dégradation par action extérieure telle que des frottements avec des surfaces en regard.

En outre, un autre avantage considérable de l'invention réside dans l'accessibilité à l'espace sous la lame flexible réfléchissante du réflecteur, ceci en cas de besoin de réparation du câblage situé dans cet espace. En effet, une fois que les cellules solaires et les réflecteurs du panneau sont installés, le câblage sous le toit des réflecteurs étant également mis en place, une série de tests est mis en oeuvre pour vérifier le fonctionnement de chacun des éléments du panneau. En cas de défauts de fonctionnement de l'un des câbles, il est obligatoire, en adoptant les réflecteurs à concentration locale tel que décrit dans le brevet US 6,177,627, de retirer l'intégralité du réflecteur pour accéder au câblage associé. Grâce à l'invention, il n'est plus nécessaire de retirer le réflecteur. Il suffit d'écarter la lame flexible pour que l'accessibilité ainsi souhaitée soit effective.

Selon un mode de réalisation, seule la face supérieure est recouverte d'un film optiquement apte à réfléchir le rayonnement solaire, éventuellement recouvert d'un revêtement de protection.

Selon un mode de réalisation, ledit matériau flexible présente des propriétés mécaniques telles qu'à l'équilibre de la première position, ladite face supérieure présente une concavité.

Selon un mode de réalisation, ledit matériau flexible présente des propriétés mécaniques telles qu'à l'équilibre de la première position, chaque réflecteur forme un plan à l'exception de leur extrémité libre qui présente une courbure vers l'extérieur de manière à supporter la mise en contact lors de la phase de libération de la pression verticale.

Selon un mode de réalisation, les surfaces des faces inférieures présentent un coefficient de frottement $\Phi$ tel que : $\text{tg } \Phi < 0.25$.

Selon un mode de réalisation, les deux faces supérieures de chaque couple sont pliées sur elles-mêmes dans des sens opposés dans la seconde position.

Selon un mode de réalisation, pour chaque couple, dans la seconde position, une première face supérieure d'un premier réflecteur est orientée vers le plan du panneau alors que le second réflecteur est orienté pour faire face à la surface inférieure du premier réflecteur.

L'invention a également pour objet un véhicule spatial, notamment satellite, caractérisé en ce qu'il comporte un panneau de générateur solaire selon l'invention.

D'autres caractéristiques et avantages de l'invention apparaîtront plus clairement à la lecture de la description suivante des exemples particuliers de réalisation en référence aux figures suivantes :

- la figure 1, déjà décrite, représente un système à panneau solaire et réflecteurs associés, selon un premier concept de l'art antérieur,
- les figures 2a et 2b, déjà décrites, représentent des réflecteurs selon un second concept de l'art antérieur,
- la figure 3 représente, schématiquement une vue en perspective d'un panneau de générateur solaire selon un mode de réalisation de l'invention,
- la figure 4a illustre une coupe, selon une section transversale, du panneau de la figure 3 en configuration dégerbée, la vue étant focalisée au niveau d'un couple de réflecteurs en regard, alors que la figure 4b illustre la même coupe que précédemment en configuration gerbée,
- la figure 5a représente l'évolution du facteur de concentration en fonction de l'angle d'incidence pour une configuration donnée,
- la figure 5b montre l'impact de la concavité des réflecteurs sur le facteur de concentration optique $C_{optique}$,
- la figure 5c montre l'effet conjoint de la concavité et de l'angle d'incidence des réflecteurs sur le facteur de concentration optique $C_{optique}$,
- la figure 5d montre la sensibilité du facteur de concentration optique $C_{optique}$ en fonction de l'angle d'incidence relié lui-même à la concavité,
- la figure 6a représente, selon un autre mode de réalisation de l'invention, un couple de réflecteurs en position gerbée des panneaux, la figure 6b représentant cette même configuration sur plusieurs couples de réflecteurs entourant plusieurs chaînes de cellules, alors que la figure 6c illustre le panneau de la figure 6b en configuration dégerbée des panneaux.

Sur les figures suivantes, des éléments remplissant des fonctions identiques porteront les mêmes références.

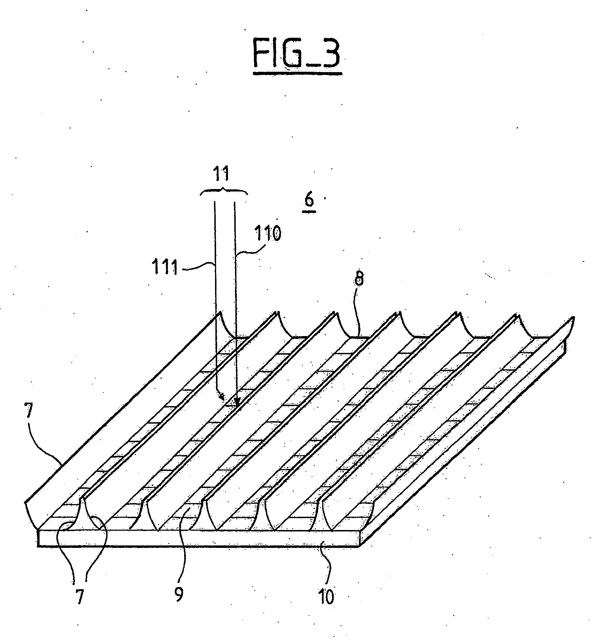

Sur la figure 3, il est représenté, schématiquement, une vue en perspective d'un panneau 6 de générateur solaire selon un mode de réalisation de l'invention.

Ce panneau 5 présente, sur sa face destinée à être orientée vers la source lumineuse, une succession alternée de réflecteurs 7 et de chaînes 8 de cellules 9 photovoltaiques. On note que, dans ce mode de réalisation des réflecteurs, ceux-ci ont été choisis selon une configuration légèrement concaves. Comme il sera expliqué dans la suite, il peut être envisagé d'autres formes de réflecteurs. Les réflecteurs et les cellules sont supportés par un panneau 10 support.

Sur la figure 3, est représenté, sous forme de plusieurs flèches, un flux solaire 11 dont certains faisceaux 110 illuminent directement la cellule 9 alors que d'autres 111 atteignent la cellule suite à une réflexion sur un réflecteur 7.

En outre, on notera sur la figure 3 que les cellules et réflecteurs sont agencés suivant la longueur (c'est à dire parallèle à une direction s'éloignant du corps du satellite) des panneaux , ceci afin de ne pas être affectés par la variation saisonnière d'incidence du flux solaire.

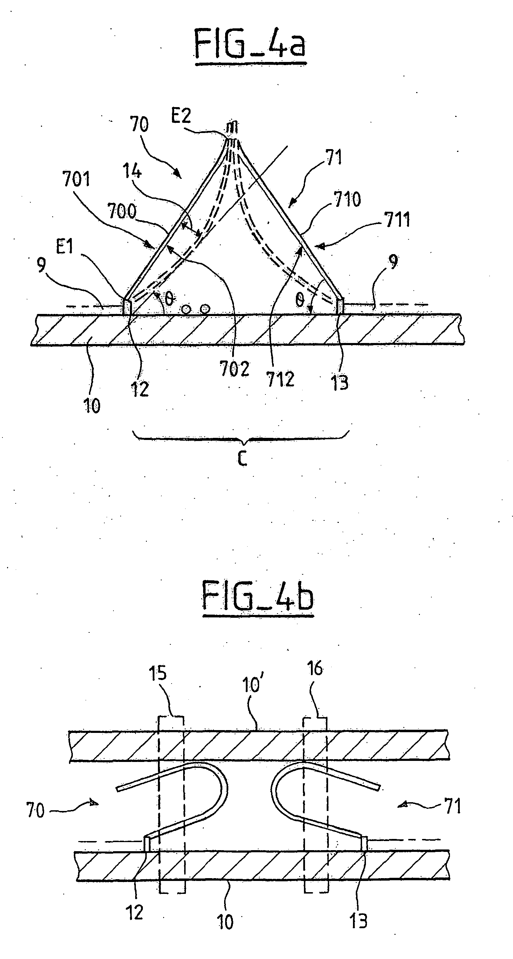

La figure 4a illustre une coupe selon une section transversale du panneau de la figure 3 en configuration dégerbée, la vue étant focalisée au niveau d'un couple C de réflecteurs 70, 71, alors que la figure 4b illustre la même coupe que précédemment en configuration gerbée..

Chaque réflecteur 70, 71 est composé d'une lame flexible comportant un matériau métallique et flexible. Ce matériau est, par exemple, du Titane. Bien entendu, tout autre matériau remplissant les conditions souhaitées de flexibilité et d'érectilité (en l'occurrence, tendance au redressement en l'absence de pression contraire) peut être envisagé. Le Titane est recouvert sur les faces supérieures des lames 70, 71, par déposition sous vide (dit "VDA" pour "Vacuum Deposit Ag"), d'un film 700, 710 optiquement réfléchissant, du type de l'Argent, lui-même recouvert, de façon non représenté, d'un revêtement de protection. Cette caractéristique de la lame lui permet de réfléchir les rayons solaires incidents vers la cellule 9 en regard.

A partir d'une configuration gerbée qui sera décrite dans la suite et consécutivement à une libération des panneaux, la configuraion dégerbée des panneaux, telle que représentée sur la figure 4a, permet aux réflecteurs de se redresser naturellement dans leur position non contrainte. Comme illustré, les deux réflecteurs étant associés respectivement à deux chaînes de cellules adjacentes, sont en regard l'un de l'autre. Chaque lame 70, 71 étant respectivement fixée à l'une de ses extrémités E1, E2 au panneau 10 par des moyens de fixation 12, 13 connus en soi, leur autre extrémité libre se retrouve naturellement en contact, exerçant une même pression l'une contre l'autre dans une position d'équilibre.

On notera que l'extrémité E2 peut présenter une légère courbure vers l'extérieur de manière à supporter la mise en contact des deux lames 70, 71 lors de la phase de libération de la pression verticale.

Selon une variante avantageuse de l'invention, illustrée en pointillés sur la figure 4a, le matériau flexible utilisé pour la lame présente des propriétés mécaniques telles qu'en position d'équilibre où les lames en regard reposent l'une contre l'autre, les faces supérieures 701, 711 de chacune d'elles présentent une certaine concavité. Il va être expliqué dans la suite l'intérêt d'une telle disposition.

Comme mentionné ci-dessus, on soulignera déjà l'avantage résultant de la configuration en concentration locale comme résidant dans la diminution des effets de distorsion des réflecteurs sur la puissance fourni par le panneau solaire. Cela se traduit par un meilleur facteur de concentration.

Dans le cas de la présente invention, le facteur de concentration Cgeometrique est fonction de l'angle θ d'inclinaison des réflecteurs par rapport au plan du panneau de support, ceci selon la relation :

$$\text{Cgéométrique} = 1+2\sin(2\theta-90°).$$

La limite théorique de ce facteur est : Cgéométrique = 3.

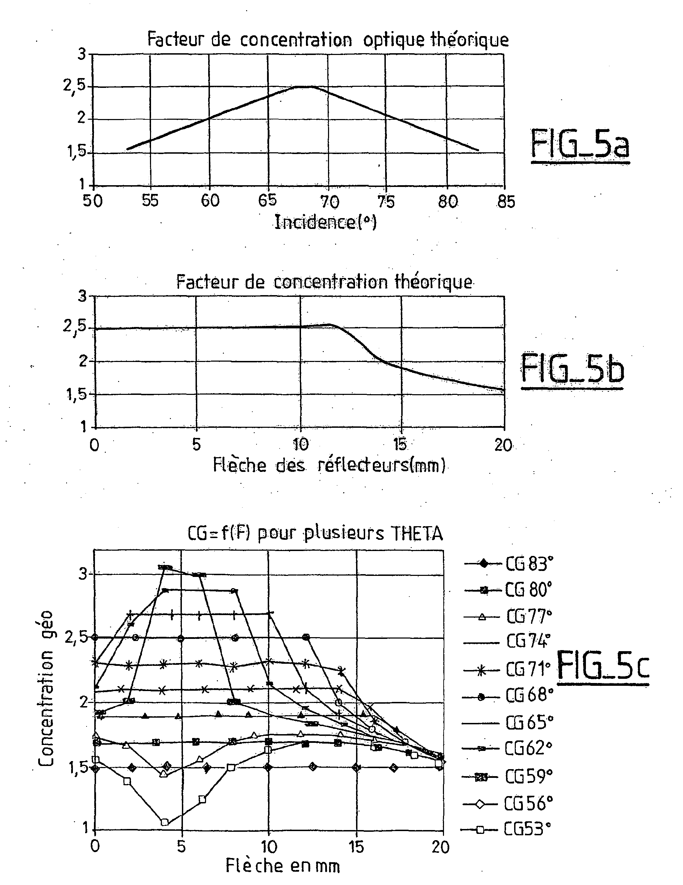

Dans le cas pratique où, les réflecteurs ont une longueur 2L par rapport à la cellule 9 de dimension L, tel que représenté sur la figure 4a, le facteur optique théorique obtenu par la méthode du "Ray-tracing", atteint un optimum égal à 2,5 pour une incidence correspondant à θ=68°, tel que l'on peut le constater sur la figure 5a illustrant le facteur de concentration optique théorique en fonction de l'incidence θ. Ceci présuppose que le rendement de réflectivité des réflecteurs soit de R=1 et que les réflecteurs soient parfaitement plans. La figure 5b représente l'effet de la présence d'une courbure ou concavité, illustrée par une double flèche 14 (figure 4a) s'exerçant sur une paroi de réflecteur. La dimension d'une telle flèche correspond à la distance entre la position plane du réflecteur et le point de la courbure le plus éloigné du réflecteur plan. Une double flèche de plus de 10mm contribue à une diminution brutale du facteur de concentration optique.

Toute concavité des réflecteurs entraîne une variation des angles d'incidence des réflecteurs. Dans le cas initial pratique de $C_{optique}$ =2,5, la figure 5c montre la variation du facteur de concentration pour différentes longueurs de flèches et par conséquent différents angles d'incidence.On s'aperçoit que l'optimum se situe pour des flèches voisines de 4mm ($C_{optique}$ >3 et supérieur au facteur de concentration initial 2,5). En fait, lorsque l'inclinaison des réflecteurs diminue, la surface vue par le soleil de ces réflecteurs augmente et l'énergie potentielle reçue augmente. Dans le cas de réflecteurs plans, cette énergie n'est pas renvoyée vers la cellule mais lorsqu' ils présentent une courbure, cette énergie peut être renvoyée sur la cellule et ainsi augmenter le facteur de concentration.

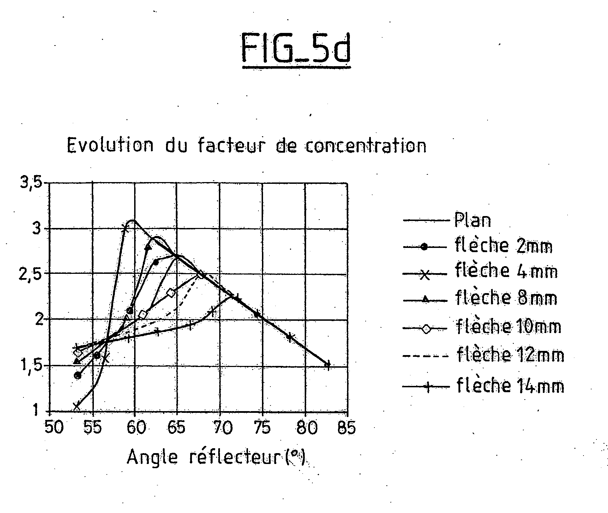

Pour une flèche de 4mm , $C_{optique}$ peut devenir supérieur au $C_{optique}$ initial mais devient très sensible à l'angle d'incidence θ comme montré sur la figure 5d.

Le facteur de concentration optique dépend du rendement R optique du matériau du film réfléchissant soit : $C_{optique} = 1+R(C_{optique\ R=1}-1 )$. Par exemple, pour R=1 , $C_{optique}$ =2.5 et pour R=0.88, $C_{optique} = 2.32$.

Typiquement, pour avoir un facteur de concentration optique stable à 10%, il faut une stabilité d'incidence de $\pm$ 4° et une flèche inférieure à 12mm.

Il est à souligner qu'autant pour le mode de réalisation illustré sur la figure 4a que pour sa variante en pointillés, les surfaces inférieures 702, 712 pourront présenter un coefficient de frottement Φ tel que tg Φ< 0.25 par exemple avec du titane.Avec une telle disposition, lors de la libération des panneaux, si les deux lames se retrouvent dans une position dissymétrique, les parties planes sans frottement des surfaces inférieures entraîneront automatiquement un mouvement d'ajustement des positions des lames vers une position d'équilibre où la symétrie serait atteinte.

La figure 4b illustre la même coupe que la figure 4a dans la configuration gerbée de panneaux 10, 10'.

Le concept astucieux de l'invention prend toute son ampleur dans la position qu'adoptent les lames en configuration gerbée des panneaux. Au sol, les surfaces supérieures 701, 711 des lames sont repliées sur elles-mêmes et en sens opposés, sous la pression du panneau supérieur 10'. Les panneaux 10, 10' sont maintenus les uns contre les autres au moyen de bandes 15, 16 de serrage.

Ainsi maintenus au sol jusqu'à leur libération, les surfaces supérieures 701, 710 des lames ne sont jamais en contact avec le panneau supérieur 10' ou un autre élément du panneau. Cette position permet au film réfléchissant de ne pas subir de dégradations par frottement.

Ces bandes sont destinées à être libérées par la suite au sol une fois que les panneaux sont repliés. Les moyens de libération ne sont pas décrits dans la présente demande car connus en soi. Il arrive souvent que les séquences {déploiement de l'aile - repliement de l'aile} interviennent à plusieurs reprises, notamment lorsque plusieurs tests sont nécessaires. On comprend alors d'autant plus que les risques de dégradations des surfaces réfléchissantes en contact se multiplient et, en conséquence, que l'invention objet de la présente demande apporte une solution radicale à ce problème par rapport à l'antérieur.

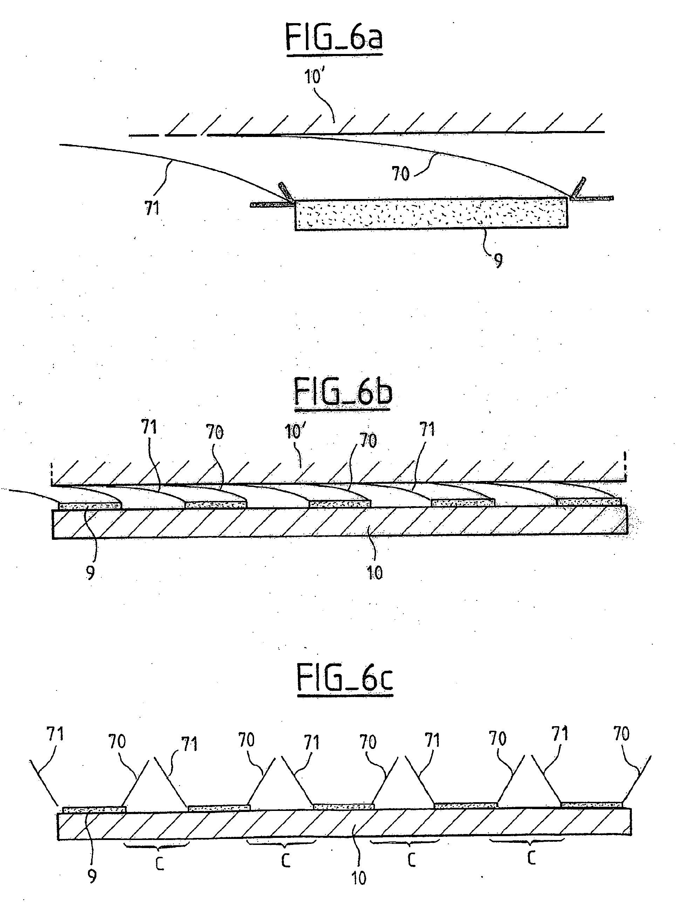

La figure 6a représente, selon un autre mode de réalisation de l'invention, un couple de réflecteurs en position gerbée des panneaux, la figure 6b représentant cette même configuration sur plusieurs couples de réflecteurs entourant plusieurs chaînes de cellules, alors que la figure 6c illustre le panneau de la figure 6b en configuration dégerbée des panneaux. Selon ce mode, en configuration dégerbée, telle que figurée sur les figures 6a et 6b, seules les surfaces supérieures des lames 71 (celles illustrées à l'extrémité gauche des cellules 9) sont pliées sur elles-mêmes, protégeant ainsi le film réfléchissant de leur paroi contre les éventuels frottements contre la paroi du panneau 10'. Par contre, les lames 70 présentent leurs surfaces supérieures contre la paroi du panneau 10' en configuration gerbée.

Le film 700 (Aluminium ou Argent ou autre matériau déposé optiquement très réfléchissant dans le visible et électriquement conducteur) est adapté pour offrir une propriété absorbante dans la gamme de fréquences infrarouges de manière à absorber sous forme de rayonnement infrarouge la chaleur emmagasinée suite à la réception du rayonnement solaire, et adapté pour offrir une propriété optique de réflexion dans la gamme des fréquences de la lumière visible. La surface inférieure 702, 712 est donc destinée à évacuer sous forme d'émission de chaleur dans le vide spatial. Celle-ci peut être un dépôt de peinture noire. Ces deux traitements de surface sont effectués sur le matérau métallique flexible de support. Dans cet exemple de réalisation, un dépôt d'Aluminium sur la paroi externe du réflecteur permet d'avoir une émissivité dans l'infrarouge de 0,3. A cela, la surface inférieure du réflecteur est recouverte d'une peinture noire à forte émissivité dans l'infrarouge. Ces dispositions ont été judicieusement apportées car, dans l'espace en raison de la micropesanteur, il ne peut y avoir de convection et la température du panneau générateur solaire est uniquement pilotée par les échanges conductifs et radiatifs avec l'environnement.

On comprend ainsi que l'invention permet, par l'utilisation de réflecteurs 70, 71 revêtus d'un film 700, 710 non seulement optiquement réfléchissant et surtout électriquement conducteur de diminuer les risques de décharges électrostatiques.

L'Aluminium étant électriquement conducteur et les réflecteurs étant placés sur la face éclairée du panneau solaire, la photo-émission permet de réduire la quantité de charge stockée dans la structure (masse électrique du satellite). Le potentiel de la structure est alors moins négatif. Le risque de décharge électrostatique dite primaire diminue. Pour cela, il est indispensable que le revêtement des réflecteurs soit conducteur et qu'il soit électriquement connecté à la masse du satellite (parties conductrices de la structure).

L'avantage de l'invention résulte également dans le fait que le plasma généré par le phénomène connu de l'Homme du Métier de décharge électrostatique primaire ne peut pas se propager entre cellules adjacentes, les réflecteurs faisant office d'écran. De plus, ce concept permet d'augmenter la distance entre le site émissif et la cellule solaire adjacente lors d'une décharge secondaire. La distance entre cellules solaires (intervalle de l'ordre de 0.8 mm) est ramenée à la distance entre le réflecteur (site émissif dans ce cas) et la cellule adjacente ; cette distance pouvant être de quelques millimètres. La tension seuil entre cellules au-dessus de laquelle un arc secondaire apparaît augmente, ce qui diminue le risque d'arc secondaire. En fait, pour ces réflecteurs, l'utilisation d'un revêtement électriquement conducteur et électriquement connecté à la masse électrique du panneau permet de diminuer les risques de décharge électrostatique dite primaire et le risque d'arc secondaire.

**Revendications**

1. Panneau (10,10') de générateur solaire, notamment pour véhicule spatial, comprenant une pluralité de réflecteurs (70,71) pour la réflexion du rayonnement solaire sur au moins une cellule (9) photovoltaique du panneau, chaque réflecteur étant formé d'une lame (70,71) de matériau flexible, une première extrémité (E1) étant fixée sur le panneau alors que la seconde (E2) demeure libre, les propriétés mécaniques du matériau flexible étant déterminées de manière pour la lame à se maintenir dressée, dans une première position, où l'extrémité libre pointe vers l'espace extérieur en l'absence de pression verticale, définissant ainsi une première face dite supérieure (701,711) faisant face à l'espace extérieur alors que la face opposée dite inférieure (702,712) fait face au panneau, et de manière pour la lame à, dans une seconde position, pouvoir présenter sa face supérieure orientée vers le plan du panneau en réponse à une pression verticale, **caractérisé en ce que** ledit panneau comporte ladite pluralité de réflecteurs regroupés par couples (C) dont les faces inférieures sont en regard dans leur première position, les réflecteurs de chaque couple étant en contact au moins par leur extrémité libre, au moins l'une des faces supérieures de chaque couple étant orientée vers le plan du panneau dans leur seconde position.

2. Panneau selon la revendication 1, **caractérisé en ce que** seule la face supérieure est recouverte d'un film (700) optiquement apte à réfléchir le rayonnement solaire, éventuellement recouvert d'un revêtement de protection.

3. Panneau selon l'une des revendication 1 et 2, **caractérisé en ce que** ledit matériau flexible présente des propriétés mécaniques telles qu'à l'équilibre de la première position, ladite face supérieure (701, 711) présente une concavité (14).

4. Panneau selon l'une des revendications précédentes, **caractérisé en ce que** ledit matériau flexible présente des propriétés mécaniques telles qu'à l'équilibre de la première position, chaque réflecteur (70,71) forme un plan à l'exception de leur extrémité libre (E2) qui présente une courbure vers l'extérieur de manière à supporter la mise en contact lors de la phase de libération de la pression verticale.

5. Panneau selon l'une des revendications précédentes, **caractérisé en ce que** les surfaces des faces inférieures présentent un coefficient de frottement $\Phi$ tel que tg $\Phi$ < 0.25.

6. Panneau selon l'une des revendications précédentes, **caractérisé en ce que** les deux faces supérieures de chaque couple sont pliées sur elles-mêmes dans des sens opposés dans la seconde position.

7. Panneau selon l'une des revendications précédentes, **caractérisé en ce que**, pour chaque couple, dans la seconde position, une première face supérieure d'un premier réflecteur est orientée vers le plan du panneau alors que le second réflecteur est orienté pour faire face à la surface inférieure du premier réflecteur.

8. Véhicule spatial, notamment satellite, **caractérisé en ce qu'**il comporte un panneau de générateur solaire selon l'une des revendications précédentes.

**Claims**

1. Solar generator panel (10, 10'), notably for spacecraft, including a plurality of reflectors (70, 71) for reflecting solar radiation onto at least one photovoltaic cell (9) of the panel, each reflector taking the form of a flexible material blade (70, 71), a first end (E1) being fixed to the panel whereas the second (E2) remains free, the mechanical properties of the flexible material being determined so that the blade is maintained erect, in a first position, in which the free end points to outer space in the absence of vertical pressure, thereby defining a first face (701, 711) known as the upper face facing outer space whereas the opposite face (702, 712) known as the lower face faces the panel, and so that, in a second position, the upper face of the blade is oriented towards the plane of the panel in response to vertical pressure, **characterized in that** said panel includes said plurality of reflectors grouped in pairs (C) the lower faces whereof are face to face in their first position, the reflectors of each pair being in contact at least at their free end, at least one of the upper faces of each pair being oriented towards the plane of the panel in the second position.

2. Panel according to Claim 1, **characterized in that** only the upper face is covered with a film (700) optically adapted to reflect solar radiation and optionally covered with a protective coating.

3. Panel according to either of Claims 1 and 2, **char-**

**acterized in that** said flexible material has mechanical properties such that in equilibrium in the first position said upper face (701, 711) is concave (14).

4. Panel according to any one of the preceding claims, **characterized in that** said flexible material has mechanical properties such that in equilibrium in the first position each reflector (70, 71) forms a plane except for its free end (E2) which is curved outwards to withstand them coming into contact during the phase of releasing the vertical pressure.

5. Panel according to any one of the preceding claims, **characterized in that** the surfaces of the lower faces have a coefficient of friction Φ such that tan Φ < 0.25.

6. Panel according to any one of the preceding claims, **characterized in that** both upper faces of each pair are folded on themselves in opposite directions in the second position.

7. Panel according to any one of the preceding claims, **characterized in that**, for each pair, in the second position, a first upper face of a first reflector is oriented towards the plane of the panel and the second reflector is oriented to face the lower surface of the first reflector.

8. Spacecraft, notably satellite, **characterized in that** it includes a solar generator panel according to any one of the preceding claims.

**Patentansprüche**

1. Solargenerator-Paneel (10, 10'), insbesondere für ein Raumfahrzeug, das mehrere Reflektore (70, 71) zur Reflexion der Sonnenstrahlung auf mindestens eine photovoltaische Zelle (9) des Paneels aufweist, wobei jeder Reflektor von einer Lamelle (70, 71) aus flexiblem Werkstoff gebildet wird, wobei ein erstes Ende (E1) am Paneel befestigt ist, während das zweite Ende (E2) frei bleibt, wobei die mechanischen Eigenschaften des flexiblen Werkstoffs so festgelegt werden, dass die Lamelle sich in einer ersten Stellung, in der das freie Ende in Abwesenheit eines senkrechten Drucks zum Außenraum weist, aufgerichtet hält, wodurch eine erste, so genannte obere Seite (701, 711) definiert wird, die dem Außenraum gegenüber liegt, während die entgegengesetzte, so genannte untere Seite (702, 712) dem Paneel gegenüberliegt, und dass die Lamelle in einer zweiten Stellung, als Reaktion auf einen senkrechten Druck, seine Oberseite zur Ebene des Paneels hin ausgerichtet präsentieren kann, **dadurch gekennzeichnet, dass** das Paneel die mehreren paarweise (C) zusammengefasste Reflektoren aufweist, deren Unterseiten in ihrer ersten Stellung einander gegenüberliegen, wobei die Reflektoren jedes Paars mindestens über ihr freies Ende in Kontakt sind, wobei mindestens eine der Oberseiten jedes Paars in ihrer zweiten Stellung zur Ebene des Paneels ausgerichtet ist.

2. Paneel nach Anspruch 1, **dadurch gekennzeichnet, dass** nur die Oberseite mit einer Folie (700) bedeckt ist, die optisch geeignet ist, um die Sonnenstrahlung zu reflektieren, ggf. mit einer Schutzverkleidung bedeckt.

3. Paneel nach einem der Ansprüche 1 und 2, **dadurch gekennzeichnet, dass** der flexible Werkstoff derartige mechanische Eigenschaften aufweist, dass im Beharrungszustand der ersten Stellung die Oberseite (701, 711) eine Hohlwölbung (14) hat.

4. Paneel nach einem der vorhergehenden Ansprüche, **dadurch gekennzeichnet, dass** der flexible Werkstoff derartige mechanische Eigenschaften aufweist, dass im Beharrungszustand der ersten Stellung jeder Reflektor (70, 71) eine Ebene mit Ausnahme seines freien Endes (E2) bildet, das eine Krümmung nach außen aufweist, um während der Phase des Freisetzens des senkrechten Drucks das Inkontaktbringen auszuhalten.

5. Paneel nach einem der vorhergehenden Ansprüche, **dadurch gekennzeichnet, dass** die Flächen der Unterseiten einen derartigen Reibungskoeffizient Φ haben, dass gilt tgΦ < 0.25.

6. Paneel nach einem der vorhergehenden Ansprüche, **dadurch gekennzeichnet, dass** die zwei Oberseiten jedes Paars in der zweiten Stellung in entgegengesetzte Richtungen auf sich selbst gefaltet sind.

7. Paneel nach einem der vorhergehenden Ansprüche, **dadurch gekennzeichnet, dass** für jedes Paar in der zweiten Stellung eine erste Oberseite eines ersten Reflektors zur Ebene des Paneels gerichtet ist, während der zweite Reflektor ausgerichtet ist, um der Unterseite des ersten Reflektors gegenüberzuliegen.

8. Raumfahrzeug, insbesondere Satellit, **dadurch gekennzeichnet, dass** es ein Solargenerator-Paneel nach einem der vorhergehenden Ansprüche aufweist.

## FIG_1

## FIG_2a

## FIG_2b

## FIG_3

## FIG_4a

## FIG_4b

Facteur de concentration optique théorique

FIG_5a

Incidence(°)

Facteur de concentration théorique

FIG_5b

Flèche des réflecteurs(mm)

CG=f(F) pour plusieurs THETA

FIG_5c

Concentration géo

Flèche en mm

- ◆ CG 83°
- ▨ CG 80°
- △ CG 77°
- CG 74°
- ✳ CG 71°
- ● CG 68°
- CG 65°
- ▨ CG 62°
- ▨ CG 59°
- ◇ CG 56°
- □ CG 53°

# FIG_5d

Evolution du facteur de concentration

Légende:
- Plan
- flèche 2mm
- flèche 4mm
- flèche 8mm
- flèche 10mm
- flèche 12mm
- flèche 14mm

Angle réflecteur (°)

## FIG_6a

10'

70

71

9

## FIG_6b

71    70    10'    70    71

9    10

## FIG_6c

71    70    71    70    71    70    71    70    71    70    71    70

9    C    C    C    C

10

**EP 1 408 557 B1**

## RÉFÉRENCES CITÉES DANS LA DESCRIPTION

**Documents brevets cités dans la description**

- US 6177627 B

- US 6118067 A